## Europäisches Patentamt

## European Patent Office

## Office européen des brevets

(11) Veröffentlichungsnummer : **0 176 778 B1**

## (12) EUROPÄISCHE PATENTSCHRIFT

(45) Veröffentlichungstag der Patentschrift :
**16.01.91 Patentblatt 91/03**

(51) Int. Cl.⁵ : **H01L 21/00, H01L 21/223,
H01L 21/265, H01L 29/06**

(21) Anmeldenummer : **85110970.2**

(22) Anmeldetag : **30.08.85**

(54) Verfahren zum Herstellen eines pn-Übergangs mit hoher Durchbruchsspannung.

(30) Priorität : **28.09.84 DE 3435830**

(43) Veröffentlichungstag der Anmeldung :
**09.04.86 Patentblatt 86/15**

(45) Bekanntmachung des Hinweises auf die
Patenterteilung :
**16.01.91 Patentblatt 91/03**

(84) Benannte Vertragsstaaten :
**DE FR GB IT SE**

(56) Entgegenhaltungen :
**EP-A- 0 095 658
EP-A- 0 115 093
DE-A- 1 564 882
US-A- 4 648 174**

(73) Patentinhaber : **Siemens Aktiengesellschaft
Wittelsbacherplatz 2
D-8000 München 2 (DE)**

(72) Erfinder : **Stengl, Reinhard, Dipl.-Phys.
Birnauerstrasse 16
D-8000 München 40 (DE)**
Erfinder : **Gösele, Ulrich, Dr. Dipl.-Phys.
Brunnenweg 21
D-7022 Leinfelden-Echterdingen (DE)**
Erfinder : **Fellinger, Christine
Germersheimerstrasse 5
D-8000 München 90 (DE)**

EP 0 176 778 B1

## Beschreibung

Die Erfindung bezieht sich auf Verfahren zum Herstellen eines pn-Übergangs mit hoher Durchbruchsspannung an der Grenzfläche eines dotierten Halbleiterkörpers nach den Oberbegriffen der Ansprüche 1 oder 2.

Bekannte Verfahren dieser Art weisen einen Schritt auf, in dem zugleich mit dem pn-Übergang ein oder mehrere diesen umgebende feldbegrenzende Ringstrukturen in den Halbleiterkörper eindiffundiert werden. Diese Ringstrukturen, deren Eindringtiefe der des pn-Übergangs entspricht, sind im Betrieb von äußeren Potentialen freigeschaltet und wirken als Spannungsteiler, wobei die Teilungsverhältnisse durch ihre gegenseitigen Abstände und den Abstand der innersten Ringstruktur vom pn-Übergang bestimmt sind. Hierzu sei auf das Buch von A. Blicher "Thyristor Physics", Springer Verlag 1976, Seiten 231 bis 234, verwiesen. Der Nachteil solcher Ringstrukturen liegt darin, daß sie zur Erzielung hoher Durchbruchsspannungen eine relativ große Halbleiterfläche benötigen und sehr empfindlich gegen Oberflächenladungen sind.

Der Erfindung liegt die Aufgabe zugrunde, Verfahren der eingangs genannten Art anzugeben, die die Herstellung eines flächensparenden pn-Übergangs mit hoher Durchbruchsspannung gewährleisten. Das wird erfindungsgemäß durch eine Ausbildung derselben nach den kennzeichnenden Teilen des Anspruchs 1 oder des Anspruchs 2 erreicht

Obwohl die erfindungsgemäßen Verfahren auf nur relativ geringfügigen Modifikationen der herkömmlichen Verfahren beruhen, ermöglichen sie die Herstellung von pn-Übergängen, die bei relativ geringem Aufwand an Halbleiterfläche eine Durchbruchsspannung aufweisen, die der Durchbruchsspannung für den parallel zur Grenzfläche des Halbleiterkörpers verlaufenden Teil des pn-Übergangs, das heißt der Volumensdurchbruchsspannung, entspricht.

Die Ansprüche 3 bis 9 sind auf vorteilhafte Ausgestaltungen und Weiterbildungen der erfindungsgemäßen Verfahren gerichtet.

Die Erfindung wird nachfolgend anhand der Zeichnung näher erläutert. Dabei zeigt :

Figur 1 einen Querschnitt durch die Randzone eines nach einem erfindungsgemäßen Verfahren hergestellten pn-Übergangs,

Figur 2 eine Draufsicht auf eine bei der Durchführung der erfindungsgemäßen Verfahren verwendete Dotierungsmaske und

Figur 3 die Isokonzentrationslinien eines erfindungsgemäß hergestellten pn-Übergangs.

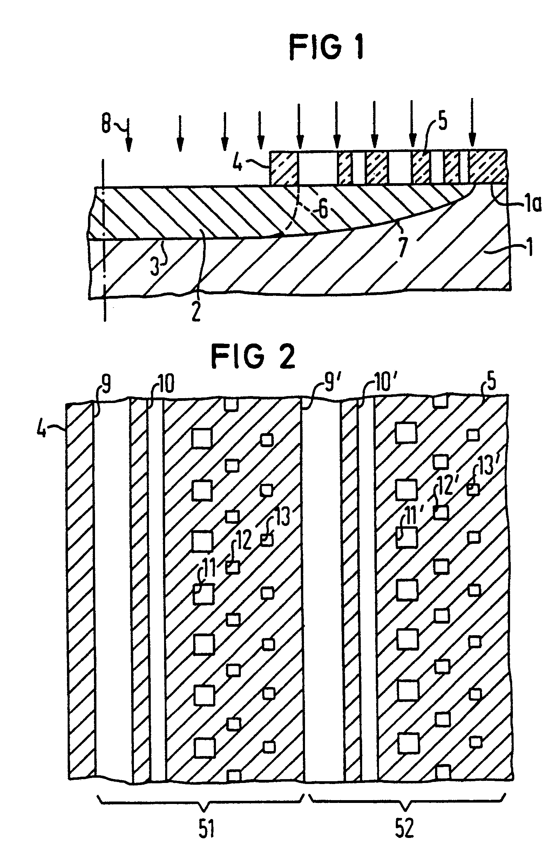

In Figur 1 ist ein Halbleiterkörper 1, zum Beispiel aus n-dotiertem Silizium mit einer Dotierungskonzentration von $10^{14}$ cm$^{-3}$, dargestellt, in den ein p-leitendes Halbleitergebiet 2 eingefügt ist Wird der pn-Übergang zwischen 1 und 2 mit einer Spannung beaufschlagt, durch die der Halbleiterkörper 1 auf ein positiveres Potential gelegt wird als das Gebiet 2, so fließt beim Erreichen eines Spannungswertes, der der sogenannten Volumensdurchbruchsspannung entspricht, ein Durchbruchsstrom innerhalb des mit 3 bezeichneten Teiles des pn-Übergangs, in dem die Grenzfläche zwischen 1 und 2 etwa parallel zur Grenzfläche 1a von 1 verläuft. Üblicherweise erzeugt man den pn-Übergang 1, 2 nach einem Verfahren, bei dem ein Dotierstoff, zum Beispiel Bor, durch die Öffnung 4 einer eine gleichmäßige Dicke aufweisenden Dotierungsmaske 5 im Wege einer Diffusion in den Halbleiterkörper 1 eingebracht wird. Dabei entsteht eine laterale Begrenzung 6, die einen so kleinen Krümmungsradius aufweist, daß ein Durchbruch an dieser Stelle bei einer Spannung erfolgt, die wesentlich unterhalb der genannten Volumensdurchbruchsspannung liegt.

Mit der Erfindung wird das Problem gelöst, den pn-Übergang 1, 2 mit einer lateralen Begrenzung 7 herzustellen, wobei sich das Dotierprofil in diesem Bereich der Grenzfläche 1a so allmählich annähert, daß auch für den mit 7 bezeichneten Teil der Begrenzung eine sehr hohe, mit der Volumensdurchbruchsspannung vergleichbare Durchbruchsspannung erreicht wird.

Nach einem ersten erfindungsgemäßen Verfahren werden Dotierstoffionen in einem ersten Verfahrensschritt mittels einer Ionenimplantation, die durch Pfeile 8 angedeutet ist, in den Halbleiterkörper 1 eingebracht, wobei zur Bildung des pn-Übergangs 1, 2 eine Dotierungsmaske 5 mit einer Öffnung 4 verwendet wird, die in der die Öffnung 4 begrenzenden Randzone 51 mit kleineren zusätzlichen Öffnungen 9 bis 13 versehen ist. Diese sind mit zunehmendem Abstand vom Rand der Öffnung 4 jeweils kleiner bemessen. Ein Teil der Maske 5 ist in der Draufsicht von Figur 2 aus Gründen der Übersichtlichkeit schraffiert dargestellt. Man erkennt, daß die Öffnungen 9 und 10 streifenförmig ausgebildet sind, wobei die letztere eine geringere Breite aufweist, während die Öffnungen 11 bis 13 lochartig ausgebildet sind und insbesondere quadratische Begrenzungen aufweisen, die mit wachsender Entfernung vom Rand der Öffnung 4 jeweils kleinere Seitenlängen haben. Die Flächen aller in einem konstanten Abstand zum Rand der Öffnung 4 liegenden Öffnungen 11 bilden eine Summenfläche, die kleiner ist als die Fläche der streifenförmigen Öffnung 10. Weiterhin ergeben die Flächen aller einen konstanten Abstand zum Rand der Öffnung 4 aufweisenden Öffnungen 12 eine Summenfläche, die ihrerseits kleiner ist als die Summenfläche der Öffnungen 11, und so weiter.

In einem zweiten Verfahrensschritt, der Nachdiffusion (auch als Temperaturbehandlung oder Temperschritt bezeichnet), werden dann bei einer Temperatur, die im allgemeinen 500 bis 1200°C beträgt und zum Beispiel bis zu 40 Stunden auf den Halbleiterkörper 1 einwirkt, die durch die Öffnungen 4 und 9 bis 13 angebrachten Dotierstoffatome weiter in den Halbleiterkörper 1 eindiffundiert. Die durch die Öffnungen 9 bis 13 eingedrungenen Dotierstoffmengen wirken hierbei als diskrete Diffusionsquellen, die durch die Lage dieser Öffnungen örtlich bestimmt sind. Die aus diesen Quellen eindiffundierten Dotierstoffatome bilden ein Dotierprofil 7, das sich mit zunehmendem Abstand vom Rand der Öffnung 4 der Grenzfläche 1a ganz allmählich annähert, wogegen die durch die Öffnung 4 implantierten Dotierstoffatome ein im wesentlichen parallel zu 1a verlaufendes Dotierprofil 3 ergeben. Die Grenze 3, 7 des pnÜbergangs entsteht dabei in einer Eindringtiefe, in der die Konzentration des implantierten Dotierstoffes auf den Wert der Grunddotierung des Halbleiterkörpers 1 abgesunken ist.

Geht man von dem Halbleiterbereich unterhalb der Öffnung 4 aus, so ergibt sich für den Bereich unterhalb der die Öffnungen 9 bis 13 enthaltenden Randzone der Maske 5 eine im Mittel geringere und örtlich variierende Implantationsdosis.

Die zusätzlichen Öffnungen 11 bis 13 können nach vorteilhaften Ausgestaltungen der Erfindung rechteckige, kreisför mige oder weitere rationell herstellbare Begrenzungen aufweisen, ebenso können die Öffnungen 9 und 10 durch weitere Reihen von Öffnungen ersetzt sein, die lochartig ausgebildet sind. Andererseits können die Öffnungen 11 bis 13 durch entsprechende, mit wachsendem Abstand vom Rand der Öffnung 4 immer schmaler bemessene streifenförmig ausgebildete Öffnungen ersetzt sein. Eine vorteilhafte Möglichkeit, die Implantationsdosis zu variieren, liegt auch darin, die einzelnen Reihen von Öffnungen bzw. die streifenförmigen Öffnungen in ihren gegenseitigen Abständen entsprechend zu bemessen oder auch die Abstände der Öffnungen 11 bis 13 innerhalb der einzelnen Reihen zu variieren.

Eine Weiterbildung des ersten erfindungsgemäßen Verfahrens sieht vor, die Maske 5 nicht nur mit einer Randzone 51, sondern mit zwei nebeneinander liegenden Randzonen 51 und 52 auszubilden, die mit Vorteil jeweils gleichartig strukturiert sind. Die Öffnungen der Randzone 52, die den Öffnungen 9 bis 13 größenmäßig und lagemäßig entsprechen, sind mit 9' bis 13' angedeutet. Bemisst man die Implantationsdosis, die dem Halbleiterkörper 1 durch die Öffnungen der Randzone 52 zugeführt wird, kleiner als die Implantationsdosis, die durch die Öffnungen der Randzone 51 eingebracht wird, so wird derselbe Effekt erreicht, als wenn die weiteren Öffnungen 9' bis 13' im Vergleich zu den Öffnungen 13 noch weiter verkleinert wären. Zur Erzielung einer kleineren Implantationsdosis für die Randzone 52 wird der erste Verfahrensschritt in zwei Teilschritte unterteilt, von denen der erste aus einer Implantation besteht, die mit einer kleineren Implantationsdosis von zum Beispiel $2 \times 10^{12}$ cm$^{-2}$

durchgeführt wird und neben der Öffnung 4 beide Randzonen 51 und 52 betrifft, während der zweite Teilschritt aus einer Implantation besteht, die mit einer größeren Implantationsdosis von zum Beispiel $1,4 \times 10^{14}$ cm$^{-2}$ durchgeführt wird, sich aber nur auf die Öffnung 4 und die Randzone 51 bezieht, was durch eine Abdeckung der Randzone 52 mittels einer weiteren Dotierungsmaske erreicht wird.

Ein zweites erfindungsgemäßes Verfahren zur Herstellung des pn-Übergangs 1, 2 besteht darin, daß der Dotierstoff unter Anwendung einer Dotierungsmaske 5, die der oben beschriebenen entspricht, in diesem Fall jedoch der Grenzfläche 1a anliegen muß, mittels einer Diffusion in den Halbleiterkörper 1 eingebracht wird. Nach einer Weiterbildung dieses Verfahrens wird die Diffusion in zwei Diffusionsteilschritte unterteilt, wobei der erste Teilschritt unter Verwendung einer Maske mit zwei Randzonen 51 und 52 vorgenommen wird und beim zweiten Teilschritt eine Maske verwendet wird, die nur eine Randzone 51 aufweist. Dies wird wieder dadurch erreicht, daß die Maske 5 beim ersten Teilschritt in der in Figur 2 dargestellten Form mit zwei Randzonen 51 und 52 verwendet wird, beim zweiten Teilschritt jedoch im Bereich der Randzone 52 durch eine weitere Dotierungsmaske abgedeckt ist. Bei dieser Weiterbildung wird trotz gleich großer Öffnungen 9 und 9', 10 und 10' ..... 13 und 13' in den Randzonen 51 und 52 dieselbe Wirkung erreicht, die sonst bei einer weiteren Verkleinerung der Öffnungen 9' bis 13' gegenüber den Öffnungen 13 zu erzielen wäre.

Im Rahmen des Erfindungsgedankens kann die Dotierungsmaske 5 auch mit mehreren hintereinander liegenden Randzonen 51, 52 und so weiter ausgebildet sein, die jeweils gleichartig strukturiert sind, wobei dann entsprechend viele Teilschritte des ersten bzw. zweiten erfindungsgemäßen Verfahrens mit jeweils unterschiedlich vielen abgedeckten Randzonen durchgeführt werden. Damit kann dann entsprechend der obigen Erläuterung die gleiche Wirkung erzielt werden, als wenn jede der Randzonen Öffnungen aufweisen würde, die gegenüber den kleinsten Öffnungen der benachbarten, dem Rand der Öffnung 4 näherliegenden Randzone weiter verkleinert wären.

Die Figuren 1 und 2 zeigen jeweils nur einen Teil der Struktur des pn-Übergangs 1, 2 und einen Teil der Dotierungsmaske 5. Man kann aber die gesamte Struktur als rotationssymmetrisch auffassen, wobei die strichpunktierte Linie A in Figur 1 als eine Symmetrieachse anzusehen ist. Figur 2 zeigt dann ein Stück einer kreisringförmigen Dotierungsmaske 5.

Eine im Rahmen der Erfindung verwendete Dotierungsmaske 5 kann zum Beispiel aus Fotolack oder Siliziumdioxid bestehen. Die bei der Durchführung der erfindungsgemäßen Verfahren anzuwendenden Implantationsschritte und Diffusionsschritte bzw. deren Teilschritte sind als solche bekannt und beispielsweise in dem Buch von H. N. Rein und R. Ranfft "Integrierte Bipolarschaltungen" aus der Reihe "Halbleiter-Elektronik", Springer-Verlag Berlin 1980, auf den Seiten 37 bis 44 beschrieben.

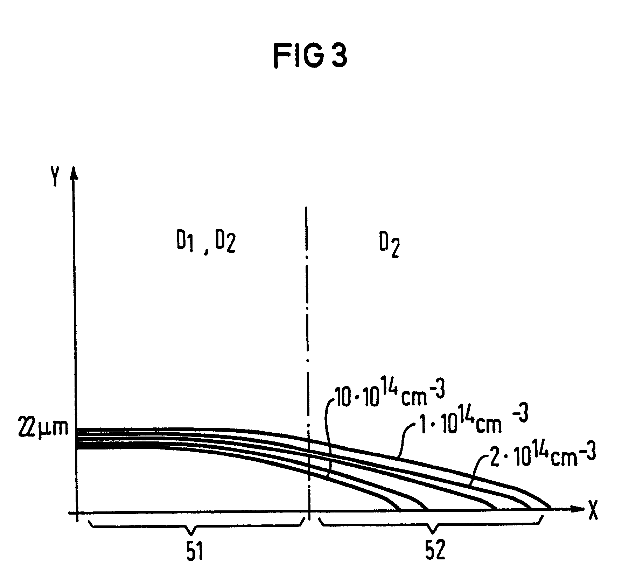

Figur 3 zeigt ein Diagramm der Isokonzentrationslinien, die bei einem nach der Erfindung dargestellten pn-Übergang, bestehend aus einem Silizium-Halbleiterkörper 1 und einem mit Bor dotierten Halbleitergebiet 2, mit einer maximalen Eindringtiefe von 22 µm vorliegen. Auf der horizontalen Achse ist der laterale Abstand x vom Rand der Öffnung 4 der Dotierungsmaske 5 linear aufgetragen, während die Eindringtiefe y in vertikaler Richtung aufgetragen ist. Es wurde das erste erfindungsgemäße Herstellungsverfahren zugrundegelegt, wobei ein erster Teilschritt mit einer Implantationsdosis von $2 \times 10^{12}$ cm$^{-2}$ auf den Bereich der Öffnung 4 und der Randzonen 51 und 52 angewendet wurde, dem sich ein zweiter Teilschritt mit einer Dosis von $1,4 \times 10^{14}$ cm$^{-2}$ anschloß, mit dem eine Dotierung des Halbleiterkörpers 1 im Bereich der Öffnung 4 und der Randzone 51 erfolgte. Die oberste Isokonzentrationslinie entspricht einer Dotierungskonzentration von $10^{14}$ cm$^{-3}$, das heißt der Grunddotierung des Halbleiterkörpers, die unterste dargestellte Linie einer Dotierungskonzentration von $10 \times 10^{14}$ cm$^{-3}$.

## Ansprüche

1. Verfahren zum Herstellen eines pn-Übergangs mit hoher Durchbruchsspannung an der Grenzfläche eines dotierten Halbleiterkörpers, bei dem ein Dotierstoff mittels eines Ionenimplantationsschrittes durch die Öffnung einer Dotierungsmaske eingebracht wird und bei dem sich ein Temperschritt anschließt, durch den die eingebrachten Dotierstoffionen tiefer in den Halbleiterkörper eindiffundieren, **dadurch gekennzeichnet,** daß eine Dotierungsmaske (5) verwendet wird, die in der die Öffnung (4) begrenzenden Randzone mit kleineren zusätzlichen Öffnungen (9 bis 13) versehen ist, die mit zunehmendem Abstand vom Rand der Öffnung (4) jeweils kleiner bemessen sind und/oder weiter voneinander entfernt sind, so daß die im Bereich der Randzone (51) eingebrachten Dotierstoffmengen beim Eindiffundieren jeweils durch die zusätzlichen Öffnungen (9 bis 13) örtlich bestimmte, diskrete Diffusionsquellen bilden und die aus diesen eindiffundierten Dotierstoffatome ein Dotierprofil (7) erzeugen, das sich mit zunehmendem Abstand vom Rand der Öffnung (4) der Grenzfläche (1a) allmählich annähert.

2. Verfahren zum Herstellen eines pn-Übergangs mit hoher Durchbruchsspannung an der Grenzfläche eines dotierten Halbleiterkörpers, bei dem der Halbleiterkörper mit einer Dotierungsmaske abgedeckt wird und bei dem ein Dotierstoff mittels einer Diffusion durch eine Öffnung der Dotierungsmaske eingebracht wird, **dadurch gekennzeichnet,** daß eine Dotierungsmaske (5) verwendet wird, die in der die Öffnung (4) begrenzenden Randzone (51) mit kleineren zusätzlichen Öffnungen versehen ist, die mit zunehmendem Abstand vom Rand der Öffnung (4) jeweils kleiner bemessen sind und/oder weiter voneinander entfernt sind, so daß die im Bereich der Randzone (51) eindiffundierenden Dotierstoffatome ein Dotierprofil (7) erzeugen, das sich mit zunehmendem Abstand vom Rand der Öffnung (4) der Grenzfläche (1a) allmählich annähert.

3. Verfahren nach Anspruch 1 oder 2, **dadurch gekennzeichnet,** daß die zusätzlichen Öffnungen (9, 10) streifenförmig ausgebildet sind.

4. Verfahren nach Anspruch 1 oder 2, **dadurch gekennzeichnet,** daß die zusätzlichen Öffnungen (11 bis 13) eine lochartige Struktur aufweisen.

5. Verfahren nach Anspruch 1 oder 2, **dadurch gekennzeichnet,** daß eine oder mehrere dem Rand der Öffnung (4) benachbarte zusätzliche Öffnungen (9, 10) streifenförmig ausgebildet sind und die in weiterer Entfernung von diesem Rand angeordneten zusätzlichen Öffnungen (11 bis 13) jeweils eine lochartige Struktur aufweisen.

6. Verfahren nach Anspruch 1, **dadurch gekennzeichnet,** daß der Ionenimplantationsschritt aus zwei Teilschritten besteht, die unter Verwendung einer Dotierungsmaske (5) durchgeführt werden, die in einer ersten, der Öffnung (4) benachbarten Randzone (51) mit ersten zusätzlichen Öffnungen (9 bis 13) versehen ist und in einer zweiten, der ersten benachbarten Randzone (52) zweite zusätzliche Öffnungen (9' bis 13') aufweist, die nach ihrer Größe und gegebenenfalls nach ihrer gegenseitigen Anordnung den ersten Öffnungen (9 bis 13) entsprechen, daß im ersten Teilschritt eine erste Implantationsdosis vorgesehen wird, mit der neben der Öffnung (4) auch die beiden Randzonen (51, 52) beaufschlagt werden und daß im zweiten Teilschritt eine zweite, die erste übersteigende Implantationsdosis vorgesehen wird, mit der neben der Öffnung (4) nur die erste Randzone (51) beaufschlagt wird.

7. Verfahren nach Anspruch 6, **dadurch gekennzeichnet,** daß der Ionenimplantationsschritt aus mehreren Teilschritten besteht, die unter Verwendung einer Dotierungsmaske mit mehreren Randzonen durchgeführt werden und daß in jedem dieser Teilschritte eine unterschiedliche Anzahl von Randzonen durch zusätzliche Dotierungsmasken abgedeckt werden.

8. Verfahren nach Anspruch 2, **dadurch gekennzeichnet,** daß die Diffusion aus zwei Teilschritten besteht, die unter Verwendung einer Dotierungsmaske (5) durchgeführt werden, die in einer ersten, der Öffnung (4) benachbarten Randzone (51) mit ersten zusätzlichen Öffnungen (9 bis 13) versehen ist und in einer zweiten, der ersten benachbarten Randzone (52) zweite zusätzliche Öffnungen (9' bis 13')

aufweist, die nach ihrer Größe und gegebenenfalls nach ihrer gegenseitigen Anordnung den ersten Öffnungen entsprechen, daß im ersten Teilschritt neben der Öffnung (4) auch die beiden Randzonen (51, 52) dem Diffusionsvorgang ausgesetzt sind und daß im zweiten Teilschritt neben der Öffnung (4) lediglich die erste Randzone (51) dem Diffusionsvorgang unterworfen wird.

9. Verfahren nach Anspruch 8, **dadurch gekennzeichnet,** daß die Diffusion aus mehreren Teilschritten besteht, die unter Verwendung einer Dotierungsmaske mit mehreren Randzonen durchgeführt werden, und daß in jedem dieser Teilschritte eine unterschiedliche Anzahl von Randzonen durch zusätzliche Dotierungsmasken abgedeckt wird.

## Claims

1. Method for the manufacture of a pn junction with high breakdown voltage at the boundary surface of a doped semiconductor body, in which a dopant is introduced through the opening of a doping mask by means of an ion implantation step, and in which an annealing step follows by means of which the introduced dopant ions diffuse deeper into the semiconductor body, characterized in that a doping mask (5) is used which is provided with smaller auxiliary openings (9 to 13) in the edge zone delimiting the opening (4), which openings are in each case dimensioned smaller and/or have a greater mutual spacing as the distance from the edge of the opening (4) increases, so that, during diffusion, the dopant quantities introduced in the region of the edge zone (51) form discrete diffusion sources locally defined in each case by the auxiliary openings (9 to 13), and which generate from these diffused dopant atoms a doping profile (7) which gradually approaches the boundary surface (1a) as the distance from the edge of the opening (4) increases.

2. Method for the manufacture of a pn junction with high breakdown voltage at the boundary surface of a doped semiconductor body, in which the semiconductor body is covered with a doping mask, and in which a dopant is introduced through an opening of the doping mask by means of diffusion, characterized in that a doping mask (5) is used which is provided with smaller auxiliary openings in the edge zone (51) delimiting the opening (4), which openings are in each case dimensioned smaller and/or have greater mutual spacing as the distance from the edge of the opening (4) increases, so that the dopant atoms diffusing in the region of the edge zone (51) generate a doping profile (7) which gradually approaches the boundary surface (1a) as the distance from the edge of the opening (4) increases.

3. Method according to Claim 1 or 2, characterized in that the auxiliary openings (9, 10) are of stripshaped design.

4. Method according to Claim 1 or 2, characterized in that the auxiliary openings (11 to 13) have a holetype structure.

5. Method according to Claim 1 or 2, characterized in that one or more of the additional openings (9, 10) adjacent to the edge of the opening (4) are of stripshaped design and the auxiliary openings (11 to 13) arranged at a greater distance from this edge in each case have a hole-type structure.

6. Method according to Claim 1, characterized in that the ion implantation step consists of two substeps, which are carried out using a doping mask (5) which is provided with first auxiliary openings (9 to 13) in a first edge zone (51) adjacent to the opening (4), and has in a second edge zone (52) adjacent to the first one second auxiliary openings (9' to 13') which correspond to the first openings (9 to 13) in terms of their size and if appropriate their mutual arrangement, in that in the first substep a first implantation dose is envisaged, to which, besides the opening (4), the two edge zones (51, 52) are also subjected, and in that in the second substep a second implantation dose exceeding the first one is envisaged, to which, besides the opening (4), only the first edge zone (51) is subjected.

7. Method according to Claim 6, characterized in that the ion implantation step consists of a plurality of substeps which are carried out using a doping mask with a plurality of edge zones, and in that a different number of edge zones is covered by additional doping masks in each of these substeps.

8. Method according to Claim 2, characterized in that the diffusion consists of two substeps which are carried out using a doping mask (5), which is provided with first auxiliary openings (9 to 13) in a first edge zone (51) adjacent to the opening (4), and has second auxiliary openings (9' to 13') in a second edge zone (52) adjacent to the first one, which openings correspond to the first openings in terms of their size and if appropriate their mutual arrangement, in that in the first substep, besides the opening (4), the two edge zones (51, 52) are also subjected to the diffusion process, and in that in the second substep, besides the opening (4), only the first edge zone (51) is subjected to the diffusion process.

9. Method according to Claim 8, characterized in that the diffusion consists of a plurality of substeps which are carried out using a doping mask with a plurality of edge zones, and in that a different number of edge zones is covered by additional doping masks in each of these substeps.

## Revendications

1. Procédé pour fabriquer une jonction pn possédant une tension de claquage élevée au niveau de la surface limite d'un corps semiconducteur dopé, selon lequel on peut insérer une substance dopante à l'aide d'une étape d'implantation ionique à travers l'ouverture d'un masque de dopage et on exécute ensuite une étape de recuit, au moyen de laquelle on fait diffuser les ions insérés de substance dopante plus profondément dans le corps semiconducteur, caractérisé par le fait qu'on utilise un masque de dopage (5), qui comporte, dans la zone marginale limitant l'ouverture (4), des ouvertures supplémentaires plus petites (9 à 13), qui possèdent des dimensions respectivement plus faibles et/ou sont plus éloignées les unes des autres lorsque la distance par rapport au bord d'ouverture (4) augmente, de sorte que les quantités de substance dopante insérées au niveau de la zone marginale (51) forment respectivement des sources discrètes de diffusion, déterminées localement par les ouvertures supplémentaires (9 à 13), et que les atomes de substance dopante, qui diffusent à partir de ces sources, produisent un profil de dopage (7) qui se rapproche progressivement de la surface limite (1a) lorsque la distance par rapport au bord de l'ouverture (4) augmente.

2. Procédé pour fabriquer une jonction pn possédant une tension de claquage élevée au niveau de la surface limite d'un corps semiconducteur dopé, selon lequel on recouvre le corps semiconducteur avec un masque de dopage et on introduit une substance dopante, au moyen d'une diffusion, dans une ouverture du masque de dopage, caractérisé par le fait qu'on utilise un masque de dopage (5), qui comporte, dans la zone marginale (51) délimitant l'ouverture (4), des ouvertures supplémentaires plus petites, qui possèdent des dimensions respectivement plus faibles et/ou sont plus éloignées les unes des autres lorsque la distance par rapport au bord de l'ouverture (4) augmente, de sorte que les atomes de substance dopante pénétrant par diffusion au niveau de la zone marginale (51) produisent un profil de dopage (7), qui se rapproche progressivement de la surface limite (1a) lorsque la distance par rapport au bord de l'ouverture (4) augmente.

3. Procédé suivant la revendication 1 ou 2, caractérisé par le fait que les ouvertures supplémentaires (9, 10) sont réalisées sous la forme de bandes.

4. Procédé suivant la revendication 1 ou 2, caractérisé par le fait que les ouvertures supplémentaires (11 à 13) possèdent une structure en forme de trou.

5. Procédé suivant la revendication 1 ou 2, caractérisé par le fait qu'une ou plusieurs ouvertures supplémentaires (9, 10), voisines du bord de l'ouverture (4), sont réalisées sous la forme de bandes et que les ouvertures supplémentaires (11 à 13), qui sont plus éloignées de ce bord, possèdent respectivement une structure en forme de trou.

6. Procédé suivant la revendication 1, caractérisé par le fait que l'étape d'implantation ionique inclut deux étapes partielles, qui sont mises en oeuvre moyennant l'utilisation d'un masque de dopage (5), qui comporte respectivement dans une première zone marginale (51) voisine de l'ouverture (4) et dans une seconde zone marginale (52) voisine de la première zone marginale, des premières ouvertures supplémentaires (9 à 13) et des secondes ouvertures supplémentaires (9' à 13'), dont la taille et éventuellement la disposition réciproque correspondent à celles des premières ouvertures (9 à 13), que lors de la première étape partielle, on prévoit une première dose d'implantation, avec laquelle on charge non seulement les ouvertures (4), mais également les zones marginales (51, 52) et que lors de la seconde étape partielle, on prévoit une seconde dose d'implantation, qui dépasse la première et avec laquelle on charge, en dehors de l'ouverture (4), uniquement la première zone marginale (51).

7. Procédé suivant la revendication 6, caractérisé par le fait que l'étape d'implantation ionique inclut plusieurs étapes partielles qui sont mises en oeuvre moyennant l'utilisation d'un masque de dopage comportant plusieurs zones marginales et que lors de chacune de ces étapes partielles, des nombres différents de zones marginales sont masquées par des masques de dopage supplémentaires.

8. Procédé suivant la revendication 2, caractérisé par le fait que la diffusion inclut deux étapes partielles qui sont mises en oeuvre moyennant l'utilisation d'un masque de dopage (5), qui comporte respectivement dans une première zone marginale (51) voisine de l'ouverture (4) et dans une seconde zone marginale (52) voisine de la première zone marginale, des premières ouvertures supplémentaires (9 à 13) et des secondes ouvertures supplémentaires (9' à 13'), dont la taille et éventuellement la disposition réciproque correspondent à celle des premières ouvertures, que lors de la première étape partielle, on soumet non seulement l'ouverture (4), mais également les deux zones marginales (51, 52) à l'opération de diffusion et que lors de la seconde étape partielle, on soumet, en dehors de l'ouverture (4), uniquement la première sone marginale (51) à l'opération de diffusion.

9. Procédé suivant la revendication 8, caractérisé par le fait que la diffusion inclut plusieurs étapes partielles qui sont mises en oeuvre moyennant l'utilisation d'un masque de dopage comportant plusieurs zones partielles, et que, lors de chacune de ces étapes partielles, des nombres différents de zones marginales sont masquées par des masques de dopage supplémentaires.

# FIG 1

# FIG 2

# FIG 3